(19) Europäisches Patentamt
European Patent Office
Office européen des brevets

(11) **EP 2 456 076 A1**

(12) **EUROPEAN PATENT APPLICATION**

(43) Date of publication:
**23.05.2012 Bulletin 2012/21**

(51) Int Cl.:
**H03M 7/30** (2006.01)

(21) Application number: **11009243.4**

(22) Date of filing: **22.11.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **22.11.2010 US 952011**

(71) Applicant: **SAP AG**
**69190 Walldorf (DE)**

(72) Inventor: **Chaves, Leonardo Weiss F.**
**69190 Walldorf (DE)**

(74) Representative: **Müller-Boré & Partner**
**Patentanwälte**
**Grafinger Straße 2**
**81671 München (DE)**

(54) **Analysis of large data sets using distributed polynominal interpolation**

(57) Embodiments of the present invention relate to analysis of large data sets using distributed polynomial interpolation. Particular embodiments compile such data sets from a large number of nodes. According to certain embodiments, a node gathers data for a certain time interval, and then approximates the gathered data with a polynomial. The node then sends its data in the form of the polynomial and an identification (ID), to a repository such as a database. For each node the polynomial may be queried from the database, and then the integral for the required interval calculated therefrom. Embodiments of the present invention may be particularly suited to allow real-time analytics of data collected from a large number of electrical power smart meters.

Fig. 1

EP 2 456 076 A1

## Description

BACKGROUND

The present invention relates to computing, and in particular, to systems and methods for a computer implemented analysis of large data sets using distributed polynomial interpolation.

Unless otherwise indicated herein, the approaches described in this section are not prior art to the claims in this application and are not admitted to be prior art by inclusion in this section.

Smart energy meters monitor and report energy consumption or production in real time. Such smart meters produce sizeable amounts of data. The efficient management and analysis of such large quantities of data remains an unsolved problem for power companies.

The processing of sizeable data volumes is usually performed either on mainframe computers, or within clusters of networked small computers. Cluster-based data processing has been promoted by the MapReduce framework, for example as described by Jeffrey Dean and Sanjay Ghemawat in "MapReduce: Simplified Data Processing on Large Clusters", OSDI'04: Sixth Symposium on Operating System Design and Implementation (2004), which is incorporated by reference herein for all purposes.

MapReduce has been implemented by various vendors, and which is being used for a number of data processing and analytics scenarios. One characteristic of this approach is batch processing. That is, the complete data set is processed in a single run.

Such processing can be repeated as soon as the underlying data set is updated. However, this approach is not suitable for online or interactive processing.

In systems like the Energy Data Management (EDM) system available from SAP AG of Walldorf, Germany, the data set is stored in a (distributed) database. This type of system may also be used for batch processing.

The present disclosure addresses these and other issues, with systems and methods for a computer implemented analysis of large data sets in real-time, which utilize distributed polynomial interpolation.

SUMMARY

Embodiments of the present invention relate to analysis of large data sets utilizing distributed polynomial interpolation. Particular embodiments compile such data sets from a large number of nodes. In particular embodiments, an individual node gathers data for a certain time interval, and then approximates the gathered data with a polynomial. The node then sends its data in the form of the polynomial and a corresponding identification (ID), for storage in a repository such as a database. For each node, the polynomial may then be queried from the database, and the integral for the required time interval calculated therefrom. Embodiments of the present invention may be particularly suited to allow real-time analytics of data collected from a large number of nodes, for example smart electrical power meters.

An embodiment of a computer-implemented method of the present invention comprises, collecting information at a node, approximating the collected information as a polynomial, transmitting the polynomial and an identifier to a repository, storing the polynomial and the identifier in a computer readable storage medium at the repository, converting the polynomial into data, and performing analytics on the data.

In an embodiment the collected information may be approximated as a polynomial utilizing a technique selected from calculation of a Lagrange polynomial, calculation of a Newton polynomial, or application of the Neville algorithm.

In certain embodiments the node may comprise an electrical smart meter, and the information may comprise electricity consumption or production.

In certain embodiments the information may be collected at the node over a time period, and the polynomial is converted into the data by integration over the time period.

In certain embodiments the repository may transmit the time period to the node.

In certain embodiments the method further comprises the node collecting additional information, the node determining whether the additional information continues to match the polynomial, and if the additional information does not continue to match the polynomial, causing the node to transmit a second polynomial to the repository.

A non-transitory computer readable storage medium according to certain embodiments may embody a computer program for performing a method comprising, collecting information at a node, approximating the collected information as a polynomial, and transmitting the polynomial and an identifier to a repository.

In certain embodiments the collected information may be approximated as a polynomial utilizing a technique selected from calculation of a Lagrange polynomial, calculation of a Newton polynomial, or application of the Neville algorithm.

In certain embodiments the node comprises an electrical smart meter, and the information comprises electricity consumption or production.

In certain embodiments the information may be collected at the node over a time period.

In certain embodiments the time period is transmitted to the node from the repository.

In certain embodiments the node collects additional information, the node determines whether the additional information continues to match the polynomial, and if the additional information does not continue to match the polynomial, the node is caused to transmit a second polynomial to the repository.

A computer system according to an embodiment of the present invention comprises one or more processors and a software program executable on said computer system and configured to, collect information at a node, approximate the collected information as a polynomial, transmit the polynomial and an identifier to a repository, store the polynomial and the identifier in a computer readable storage medium at the repository, convert the polynomial into data, and perform analytics on the data.

In certain embodiments the collected information is approximated as a polynomial utilizing a technique selected from calculation of a Lagrange polynomial, calculation of a Newton polynomial, or application of the Neville algorithm.

In certain embodiments the node comprises an electrical smart meter, and the information comprises electricity consumption or production.

In certain embodiments the information is collected at the node over a time period, and the polynomial is converted into the data by integration over the time period.

In certain embodiments the repository is configured to transmit the time period to the node.

In certain embodiments the node collects additional information and determines whether the additional information continues to match the polynomial, and if the additional information does not continue to match the polynomial, the node is caused to transmit a second polynomial to the repository.

The following detailed description and accompanying drawings provide a better understanding of the nature and advantages of the present invention.

BRIEF DESCRIPTION OF THE DRAWINGS

Fig. 1 shows a simplified view of a system configured to perform a method according to an embodiment of the present invention.

Fig. 2 shows a simplified flow chart of a method according to an embodiment of the present invention.

Fig. 3A is a simplified view showing the flow of information of a conventional approach for collecting and analyzing data from a plurality of smart meters.

Fig. 3B is a simplified view showing the flow of information of one embodiment of an approach for collecting and analyzing data from a plurality of smart meters according to the present invention.

Fig. 3C is a simplified view showing the flow of information of an alternative embodiment of an approach for collecting and analyzing data from a plurality of smart meters according to the present invention.

Fig. 4A shows a computer system at a remote node for performing a method according to one embodiment.

Fig. 4B shows a computer system at a remote node for performing a method according to one embodiment.

Fig. 5 illustrates hardware of a special purpose computing machine configured to perform analysis of large data sets according to one embodiment of the present invention.

DETAILED DESCRIPTION

Described herein are techniques for providing a computer-implemented systems and methods for analysis of large data sets, using distributed polynomial interpolation.

The apparatuses, methods, and techniques described below may be implemented as a computer program (software) executing on one or more computers. The computer program may further be stored on a computer readable medium. The computer readable medium may include instructions for performing the processes described below.

In the following description, for purposes of explanation, examples and specific details are set forth in order to provide a thorough understanding of various embodiments of the present invention. It will be evident, however, to one skilled in the art that the present invention as defined by the claims may include some or all of the features in these examples alone or in combination with other features described below, and may further include modifications and equivalents of the features and concepts described herein.

Embodiments of the present invention employ distributed approximation of large data sets (for example as are available from a plurality of individual nodes), utilizing a polynomial. A number of possible benefits are conveyed by such an approach.

One possible benefit is a significant reduction in the volumes of data required to be communicated from the nodes. Specifically, because the polynomial is being transmitted rather than an ongoing stream of the actual data, data volumes may be significantly reduced.

Another possible benefit of this approach is faster processing time. In particular the ready availability of the stored polynomial allows for rapid computation of responses to queries. In this manner, data can be managed and analyzed efficiently in near real-time.

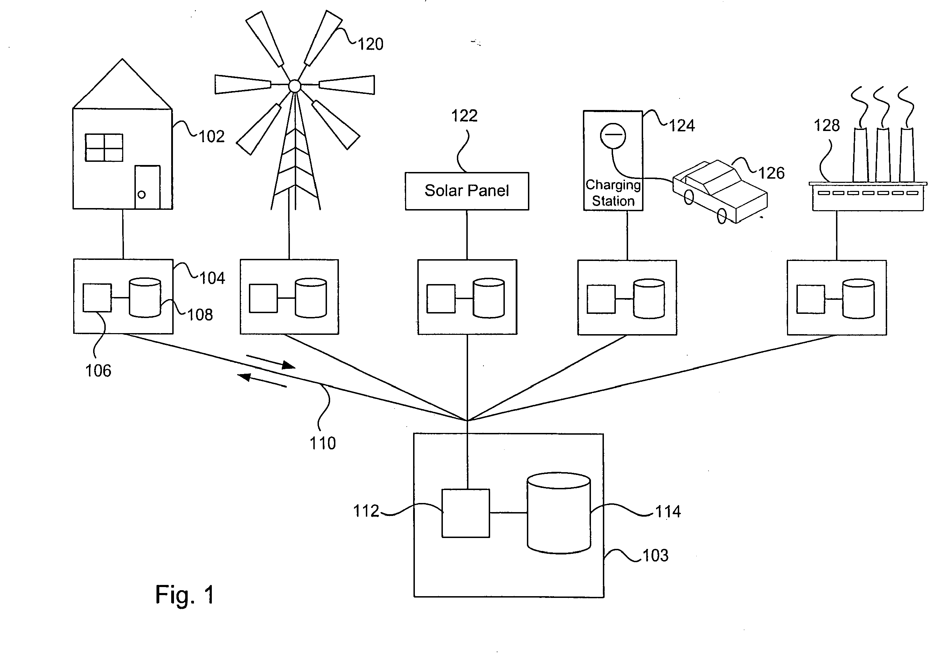

Figure 1 illustrates a simplified view of a system configured to practice a method according to an embodiment of the present invention. Figure 1 shows system 100 comprising an electrical power distribution network having a plurality of elements remote from a computer system comprising a repository 103. In certain embodiments the repository may be in a single location. In other embodiments the repository may be distributed.

One element of the electrical power distribution network comprises a residence 102 that serves as a consumer of electricity. Another element of the electrical power distribution network comprises a windmill 120 that serves as a generator of electricity. The electrical power distribution network further comprises a photovoltaic source of electricity 122, such as a solar panel. The electrical power distribution network further comprises an electrical consumer in the form of a charging station 124 for an electric car 126. The electrical power distribution network may also comprise a larger consumer of electricity 128, here a factory.

Each of the elements of the electrical power distribution network is in communication with a respective individual smart meter 104. Each of these smart meters 104 includes a processor 106 in electronic communication with a computer readable storage medium 108. Processor 106 is configured to detect an amount of electricity consumed or produced over time by the particular element, and to store this information in the computer-readable storage medium 108.

Each smart meter 104 is in communication with the computer system of the repository 103 through a data link 110. Data link 110 may be wired or wireless, and may be local or global, depending upon a particular application.

According to certain embodiments, the smart meters may be in communication with the repository through the internet. In some embodiments, communication between the smart meter and the repository may be conducted in accordance with a security protocol.

The computer system of the repository 103 itself comprises a processor 112 that is in communication with a computer readable storage medium 114. This computer system is configured to receive information from each of the smart meters, and to store that information in the storage medium 114.

According to embodiments of the present invention the processing capability of the processors 106 that are present in each of the smart meters 104, may be leveraged to reduce the volumes of data to be handled by the repository. In particular, the remote processors 106 function to gather the energy consumption or production data over a time interval (for example one day). The individual computer readable storage medium present in the smart meter, is configured to have the capacity to store at least this much data.

The time interval of data collection can, but need not be the same across different nodes. In addition, the collection of data can, but need not be synchronized to the same time intervals.

At the end of the time interval, each smart meter is configured to approximate the collected energy consumption or production data in the form of a polynomial. Estimation of the collected consumption or production data can be performed utilizing a standard method. One example of such a standard method is the calculation of a Lagrange polynomial as is known in the art. Another example of such a standard method is the calculation of a Newton polynomial. Still another example of such a standard method is the calculation of a polynomial utilizing Neville's algorithm.

Once the smart meter has created and stored the polynomial, it then sends that polynomial together with relevant identification (ID) information to the computer system of the repository 103. The processor 112 of the repository receives the polynomial and the ID, and stores them in the computer readable storage medium.

The data stored in the repository may next be analyzed in any number of ways. For example, for each smart meter and time interval, the relevant polynomial may be queried from the database. From this polynomial, the integral for the required interval (e.g. for a whole day) may be calculated.

Embodiments of the present invention may be particularly suited to allow analysis in real-time or near real-time, of data collected from the large number of smart electrical power meters. For example in certain embodiments the energy consumption or production data stored in the form of a polynomial, may be queried to calculate the energy bill of customers. Energy consumption or production data of the polynomial may also be queried to provide real-time online energy data for customers, or to plan future energy production.

Figure 1 shows the bi-directional communication of information along the link 110 between smart meter 104 and repository 103. In particular, the repository may communicate with the smart meter for one or more purposes. Examples of such communication include monitoring the health/integrity of the smart meter, and/or controlling the time interval over which consumption or production information is stored prior to calculation of the polynomial.

While Figure 1 is described in the context of a plurality of nodes in the form of smart electric utility meters, the present invention is not limited to this or any other particular device. Other examples of systems that could benefit from embodiments of methods and apparatuses according to the present invention, include but are not limited to, data from wireless sensor networks, data from RFID readers, and financial-type data such as commodity or stock price information.

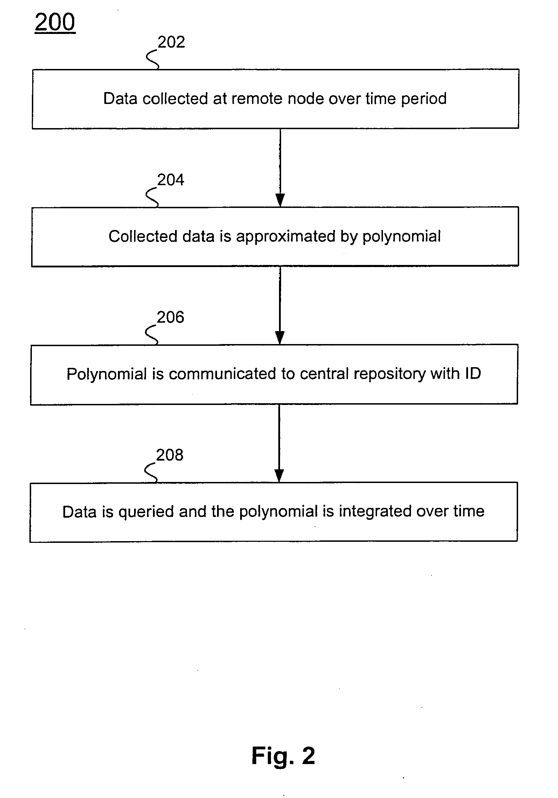

Figure 2 shows a simplified flowchart of steps performed by an embodiment of a method 200 according to the present invention. In a first step 202, data is collected over a time period at a node of a network. In step 204, the data that has been collected is approximated in the form of a polynomial.

In step 206, the polynomial is communicated from the node to a repository together with an identification. In step 208, the polynomial is queried and integrated over time.

<u>Example</u>

Embodiments according to the present invention are now described in connection with a system comprising a plurality of nodes in the form of smart electrical power meters for buildings. In this particular example, the system is configured as follows.

The power company has 10 million smart meters. Each smart meter is configured to compute energy usage every 15 minutes. It is desired to compute energy consumption or production statistics across the system for a one day time period.

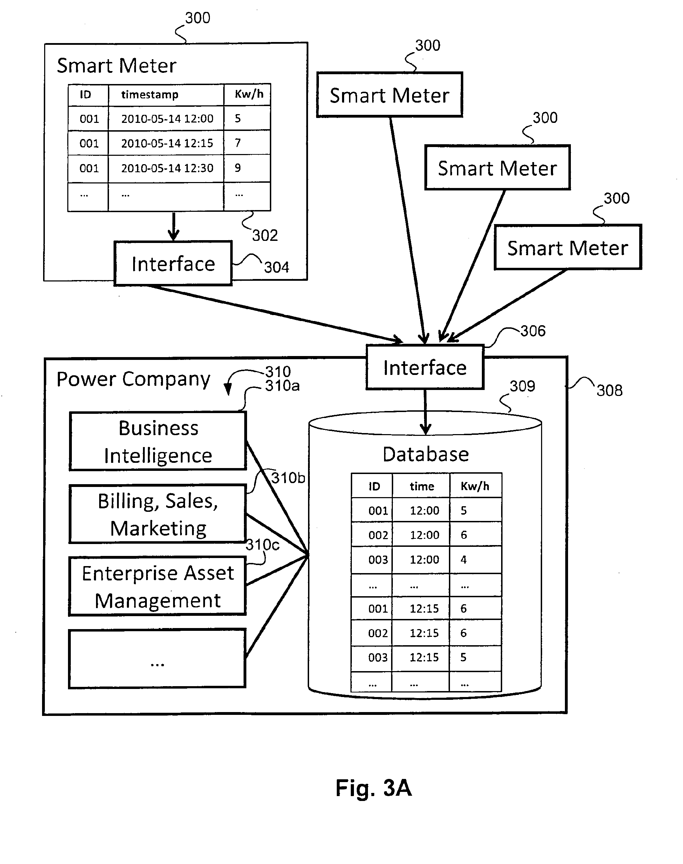

A conventional approach to managing smart meter data is illustrated in Figure 3A. As described in detail below, this conventional approach involves writing the raw data into a database, and then querying the data.

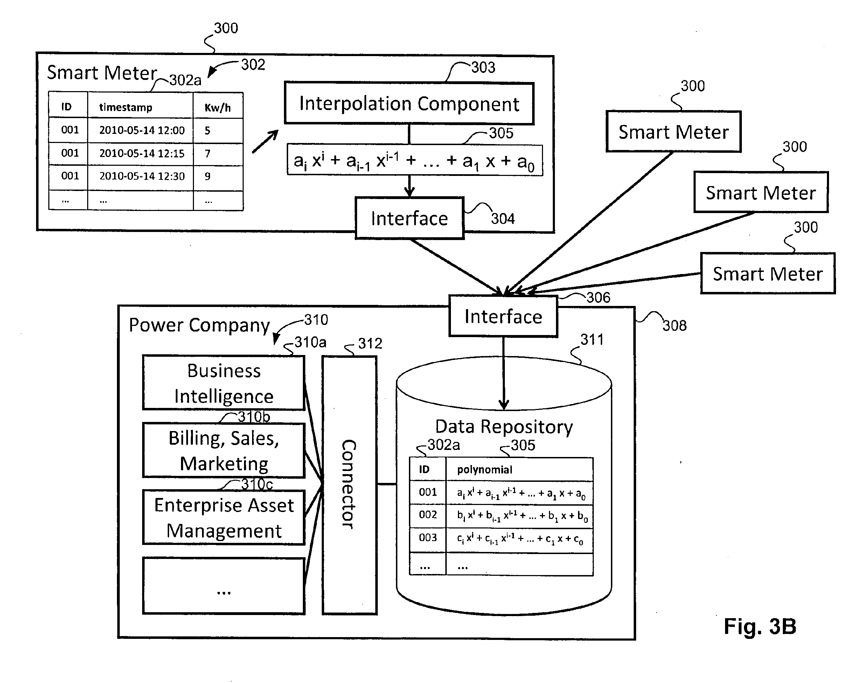

The conventional approach may be contrasted with an approach utilizing distributed polynomial interpolation according to an embodiment of the present invention, as is illustrated in Figure 3B. The following example compares an embodiment of the present invention to such a conventional method.

The effects of distribution are not considered in this example. This is because the methods for distributing the raw data in a database, also apply to distributing the approximated data in the form of a polynomial according to embodiments of the present invention.

In the conventional approach of Figure 3A, energy consumption or production data is collected and stored as follows. Each remote smart meter 300 collects and stores data 302 over the 15 minute time period in its computer readable storage medium. The smart meter then sends its collected data through an interface 304 to an interface 306 of the power company 308. The data is then stored in a central database 309.

The collected data that is transmitted comprises an ID 302a, a timestamp 302b, and the power consumption or production values (in Kw/h) 302c. Each variable is 32 bits long.

The quantity of data transmitted per smart meter per day is thus:

$$10 \text{ million meters x } 24\text{hr x } 4 \text{ measurements/hr x } 3 \text{ values/measurement x } 32 \text{ Bit/value}$$
$$= 10.7 \text{ GB per day.}$$

According to the embodiment of the present invention shown in Figure 3B, energy consumption or production data is collected and stored as follows. As with Figure 3A, the smart meter 300 collects and stores the energy consumption or production data 302 over 15 minute time periods, in its local computer readable storage medium.

Unlike Figure 3A, however, each smart meter includes an interpolation component 303. At the end of the day, this interpolation component is configured to generate a polynomial 305 from this data as an approximation. This polynomial is stored together with the corresponding identifier 302a from the data 302.

Each smart meter then sends through its interface 304 to an interface 306 of the power company 308, its collected data in the form of the polynomial 305 and a corresponding ID 302a. The data is then stored in a repository 311.

According to certain embodiments, this repository 311 might be a standard database. Alternatively, the repository 311 may be a specialized data storage. Existing methods to optimize queries might be used, e.g. horizontal and vertical partitioning, indexes, materialized views.

A polynomial of order n consists of n integers and n floating points. Data for one day might require an order of around n = 5. Again, each variable is 32 Bits long.

Thus according to this embodiment of the present invention, the quantity of data that is transmitted per smart meter per day is:

$$10 \text{ million smart meters x } (1 + 5 + 5 \text{ values}) \text{ x } 32\text{Bit/value} = 419.6 \text{ MB per day.}$$

The embodiment of this particular example thus offers a 25-fold reduction in the volume of data to be communicated from each remote smart meter to the repository, and then stored in a database.

Information that has been collected may be queried utilizing analytical tools. Examples of such analytics are described in the documents entitled "Performance and Insight Optimization Services: Predictive Analytics for the Utilities Industry", and "Enabling AMI Integration for Utilities: Optimizing Meter Data Use for Efficient, Competitive Operations", both of which are published by SAP AG, cited in the information disclosure statement accompanying this patent application, and incorporated by reference in their entireties herein for all purposes.

According to the conventional approach, the energy consumption or production data may be queried as follows. The power company includes one or more current systems, components and applications 310 that are in selective communication with the database 309. These applications 310 can include business intelligence applications 310a, billing/sales/marketing components 310b, and enterprise asset management systems 310c.

Thus for each smart meter, the metering data may conventionally be selected and aggregated:

$$\text{Number of rows in the database} = 10 \text{ million x } 24\text{hr x } 4 \text{ measurements/hr} = 960 \text{ million rows.}$$

The number of values to be selected is:

$$24\text{hr x } 4 \text{ measurements/hr} = 96 \text{ values per meter.}$$

According to an embodiment of the present invention, energy consumption or production data may be queried as follows. The current systems, components and applications 310 (e.g. ERP, analytics, billing, etc) connect to the data repository 311 through one connector 312.

The connector is configured to receive queries, and then rewrite them so that they can be answered by calculating the integral of the polynomials stored in the repository. The systems, components and applications 310 are not aware of the polynomials and do not need to be changed.

Thus for each smart meter, the polynomial is queried from the repository. Next, the integral is calculated for the required interval, that is for a whole day:

$$\text{Number of rows in the database} = 10 \text{ million rows.}$$

The number of values to be selected is:

1 value per meter.

The complexity for querying depends in a linear manner according to a number of rows in the database and a number of values to be queried. Therefore, querying according to this embodiment would be (96 x 96 = 9216) times faster than querying utilizing the conventional approach.

It is further noted that a query to a polynomial (as is the case with embodiments of the present invention), does not depend upon the size of the time interval. That is, the polynomial itself does not change based upon the length of the time period over which data is gathered.

By contrast, the collected data in the conventional approach does change over the time interval. The complexity of querying data from the conventional method is thus linearly dependent upon the size of that time interval (i.e., the number of values). That is, the complexity of the conventional method increases with the size of the time period over which data is collected. Thus in this sense as well, embodiments of the present invention offer reduced complexity as compared with conventional approaches.

Embodiments of the present invention may offer possible benefits in addition to a lowered burden of data transmission, and reduced querying complexity. For example, because the amount of data stored at the repository is smaller by orders of magnitude, metering data in polynomial form covering an entire year could fit within the main memory. Such storage facilitates the performance of analytics in real-time or near real-time.

Embodiments of the present invention are not limited to the particular example shown in Figure 3B, and variations are possible. For example, while Fig. 3B shows an embodiment wherein querying agents are in communication with the stored polynomial data through a connector, this is not required.

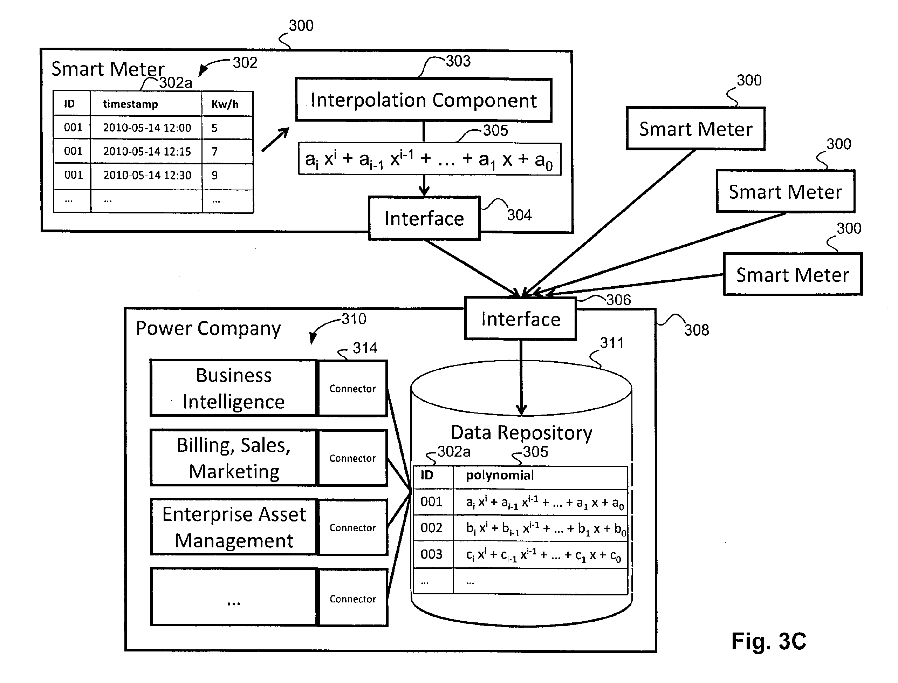

In alternative embodiments, the current systems, components and applications can natively deal with polynomials. Such an embodiment is shown in Figure 3C.

In such embodiments, a connector 314 is embedded on each system/component/application 310. These embedded connectors are configured to receive polynomials as inputs, and can perform application specific operations on them. Examples of such operations include plotting the polynomials, and calculating the intersection of difference of several polynomials.

Still other alternative embodiments may employ a mix of both above described implementations. That is, some systems/components/applications (e.g. legacy systems) will use a connector, while others will offer native support of polynomial data.

Moreover while the embodiments of Figures 3B-C show the communication of data from the local node (smart meter) collected over a regular time interval pre-defined by the power company, this is not required by the invention.

Alternative embodiments may utilize other approaches to determining an amount of data that is to be sent.

For example, according to one alternative embodiment the individual smart meters may be instructed to periodically query the power company to determine an amount of data making up polynomial (i.e. the time interval).

In other embodiments the individual smart meters may be empowered to decide dynamically how much data to use, based on the data itself. For example, the smart meter may calculate a polynomial and sent that polynomial to the power company. Where new data collected by the smart meter continues to follow this polynomial within a certain tolerance, no new polynomial needs to be computed, no information needs to be sent to the power company.

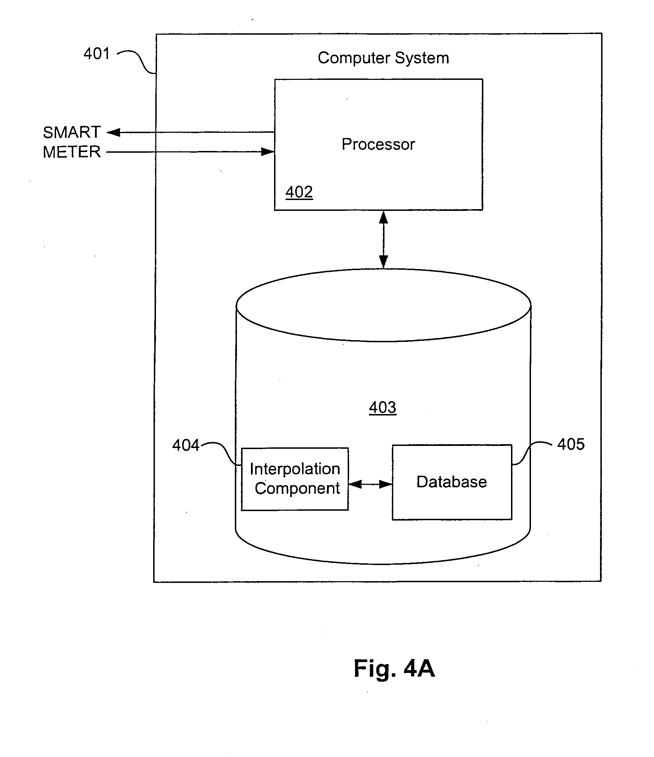

Fig. 4A illustrates hardware of a special purpose computing machine located at the remote node and configured to implement a method according to one embodiment of the present invention. In particular, computer system 401 comprises a processor 402 that is in electronic communication with a computer-readable storage medium 403. Where the computer system is located at the remote node, the storage medium 403 can comprise a storage medium such as a database, and can comprise an interpolation component as described above.

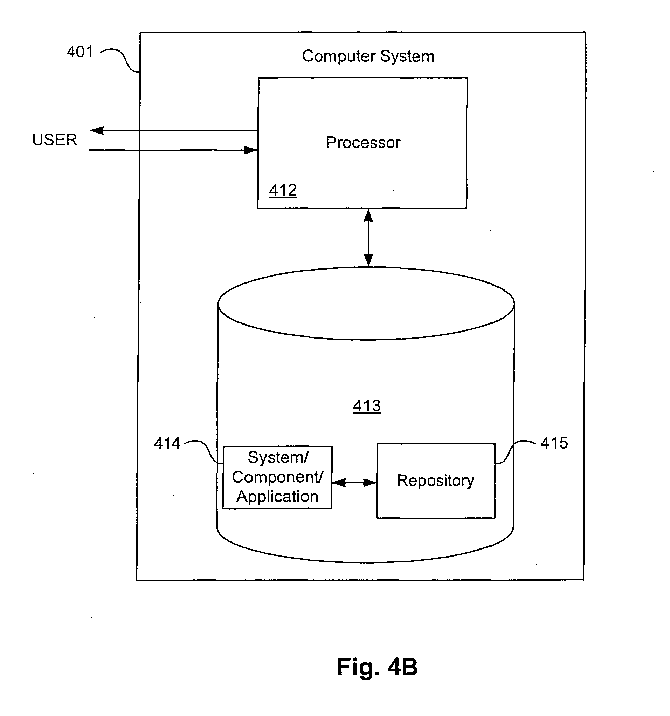

Fig. 4B illustrates hardware of a special purpose computing machine located at the central location and configured to implement a method according to one embodiment of the present invention. In particular, computer system 411 comprises a processor 412 that is in electronic communication with a computer-readable storage medium 413. Where the computer system is located at the central location, the storage medium 413 can comprise a database or data repository 414 such as a relational database, and can comprise an analytics system/component/application 415 configured to query and perform analytics of the stored polynomial data.

The computer system(s) may comprise software servers. A number of software servers together may form a cluster, or logical network of computer systems programmed with software programs that communicate with each other and work together to process requests.

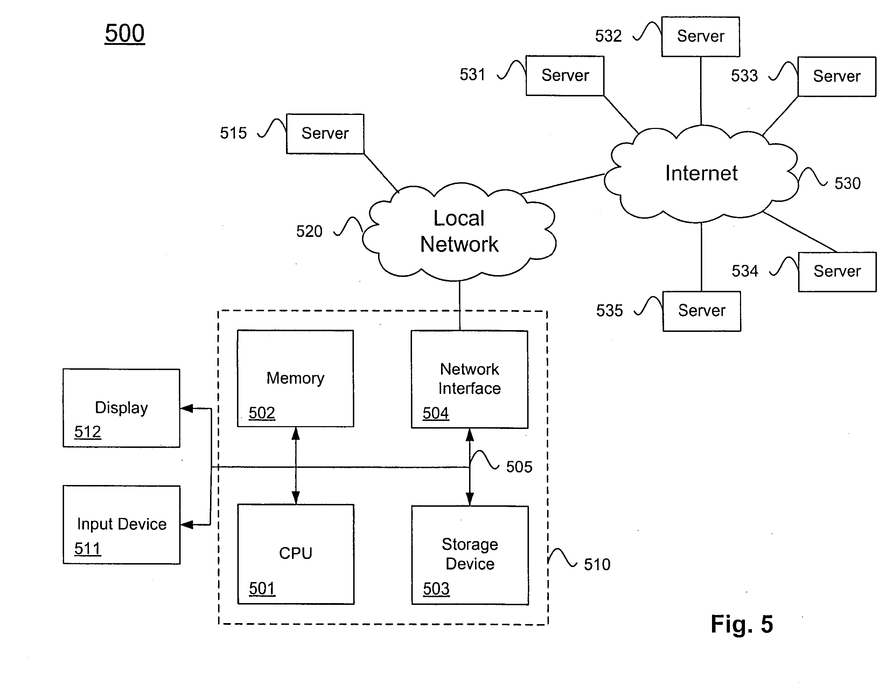

An example computer system 510 is illustrated in Fig. 5. Computer system 510 includes a bus 505 or other communication mechanism for communicating information, and a processor 501 coupled with bus 505 for processing information.

Computer system 510 also includes a memory 502 coupled to bus 505 for storing information and instructions to be executed by processor 501, including information and instructions for performing the techniques described above, for example. This memory may also be used for storing variables or other intermediate information during execution of instructions to be executed by processor 501. Possible implementations of this memory may be, but are not limited to, random access memory (RAM), read only memory (ROM), or both.

A storage device 503 is also provided for storing information and instructions. Common forms of storage devices include, for example, a hard drive, a magnetic disk, an optical disk, a CD-ROM, a DVD, a flash memory, a USB memory card, or any other medium from which a computer can read.

Storage device 503 may include source code, binary code, or software files for performing the techniques above, for example. Storage device and memory are both examples of non-transitory computer readable storage media.

Computer system 510 may be coupled via bus 505 to a display 512, such as a cathode ray tube (CRT) or liquid crystal display (LCD), for displaying information to a computer user. An input device 511 such as a keyboard and/or mouse is coupled to bus 505 for communicating information and command selections from the user to processor 501. The combination of these components allows the user to communicate with the system. In some systems, bus 505 may be divided into multiple specialized buses.

Computer system 510 also includes a network interface 504 coupled with bus 505. Network interface 504 may provide two-way data communication between computer system 510 and the local network 520. The network interface 504 may be a digital subscriber line (DSL) or a modem to provide data communication connection over a telephone line, for example. Another example of the network interface is a local area network (LAN) card to provide a data communication connection to a compatible LAN. Wireless links are another example. In any such implementation, network interface 504 sends and receives electrical, electromagnetic, or optical signals that carry digital data streams representing various types of information.

Computer system 510 can send and receive information, including messages or other interface actions, through the network interface 504 across a local network 520, an Intranet, or the Internet 530. For a local network, computer system 510 may communicate with a plurality of other computer machines, such as server 515. Accordingly, computer system 510 and server computer systems represented by server 515 may form a cloud computing network, which may be programmed with processes described herein.

In an example involving the Internet, software components or services may reside on multiple different computer systems 510 or servers 531-535 across the network. The processes described above may be implemented on one or more servers, for example. A server 531 may transmit actions or messages from one component, through Internet 530, local network 520, and network interface 504 to a component on computer system 510. The software components and processes described above may be implemented on any computer system and send and/or receive information across a network, for example.

The above description illustrates various embodiments of the present invention along with examples of how aspects of the present invention may be implemented. The above examples and embodiments should not be deemed to be the only embodiments, and are presented to illustrate the flexibility and advantages of the present invention. Based on the above disclosure and the following claims, other arrangements, embodiments, implementations and equivalents will be evident to those skilled in the art and may be employed without departing from the spirit and scope of the invention as defined by the claims.

**Claims**

1. A computer-implemented method comprising:

   collecting information at a node;
   approximating the collected information as a polynomial;
   transmitting the polynomial and an identifier to a repository;
   storing the polynomial and the identifier in a computer readable storage medium at the repository;
   converting the polynomial into data; and
   performing analytics on the data.

2. The method of claim 1 wherein the collected information is approximated as a polynomial utilizing a technique selected from calculation of a Lagrange polynomial, calculation of a Newton polynomial, or application of the Neville algorithm.

3. The method of claims 1 or 2 wherein the node comprises an electrical smart meter, and the information comprises electricity consumption or production.

4. The method of any of the preceding claims wherein the information is collected at the node over a time period, and the polynomial is converted into the data by integration over the time period, wherein the method may further comprise the repository transmitting the time period to the node.

5. The method of any of the preceding claims further comprising:

   the node collecting additional information;
   the node determining whether the additional information continues to match the polynomial; and
   if the additional information does not continue to match the polynomial, causing the node to transmit a second polynomial to the repository.

6. A non-transitory computer readable storage medium embodying a computer program for performing a method, said method comprising:

   collecting information at a node;
   approximating the collected information as a polynomial; and
   transmitting the polynomial and an identifier to a repository.

7. The computer readable storage medium of claim 6 wherein the collected information is approximated as a polynomial utilizing a technique selected from calculation of a Lagrange polynomial, calculation of a Newton polynomial, or application of the Neville algorithm.

8. The computer readable storage medium of claims 6 or 7 wherein the node comprises an electrical smart meter, and the information comprises electricity consumption or production.

9. The computer readable storage medium of any of the preceding claims wherein the information is collected at the node over a time period, and wherein the time period may be transmitted to the node from the repository.

10. The method of any of the preceding claims further comprising:

    the node collecting additional information;
    the node determining whether the additional information continues to match the polynomial; and
    if the additional information does not continue to match the polynomial, causing the node to transmit a second polynomial to the repository.

11. A computer system comprising:

one or more processors;
a software program, executable on said computer system, the software program configured to:

collect information at a node;
approximate the collected information as a polynomial;
transmit the polynomial and an identifier to a repository;
store the polynomial and the identifier in a computer readable storage medium at the repository;
convert the polynomial into data; and
perform analytics on the data.

12. The computer system of claim 11 wherein the collected information is approximated as a polynomial utilizing a technique selected from calculation of a Lagrange polynomial, calculation of a Newton polynomial, or application of the Neville algorithm.

13. The computer system of claims 11 or 12 wherein the node comprises an electrical smart meter, and the information comprises electricity consumption or production.

14. The computer system of any of the preceding claims wherein the information is collected at the node over a time period, and the polynomial is converted into the data by integration over the time period, wherein the repository may be configured to transmit the time period to the node.

15. The computer system of any of the preceding claims wherein:

the node collects additional information;
the node determines whether the additional information continues to match the polynomial; and
if the additional information does not continue to match the polynomial, the node is caused to transmit a second polynomial to the repository.

Fig. 1

EP 2 456 076 A1

<u>200</u>

202

Data collected at remote node over time period

204

Collected data is approximated by polynomial

206

Polynomial is communicated to central repository with ID

208

Data is queried and the polynomial is integrated over time

# Fig. 2

300

## Smart Meter

| ID | timestamp | Kw/h |
|-----|------------------|------|
| 001 | 2010-05-14 12:00 | 5 |
| 001 | 2010-05-14 12:15 | 7 |
| 001 | 2010-05-14 12:30 | 9 |
| ... | ... | ... |

302

Interface 304

300

Smart Meter

300

Smart Meter

300

Smart Meter

306

Interface

## Power Company 310
310a

Business Intelligence

310b

Billing, Sales, Marketing

310c

Enterprise Asset Management

...

309

308

## Database

| ID | time | Kw/h |
|-----|-------|------|
| 001 | 12:00 | 5 |
| 002 | 12:00 | 6 |
| 003 | 12:00 | 4 |
| ... | ... | ... |
| 001 | 12:15 | 6 |
| 002 | 12:15 | 6 |
| 003 | 12:15 | 5 |
| ... | ... | ... |

## Fig. 3A

Fig. 3B

**Smart Meter (302)**

| ID | timestamp | Kw/h |
|---|---|---|
| 001 | 2010-05-14 12:00 | 5 |
| 001 | 2010-05-14 12:15 | 7 |
| 001 | 2010-05-14 12:30 | 9 |
| ... | ... | ... |

302a

303 — Interpolation Component

305 — $a_i x^i + a_{i-1} x^{i-1} + \ldots + a_1 x + a_0$

304 — Interface

Smart Meter (300)

306 — Interface

308 — Data Repository (311)

**305**

| ID | polynomial |
|---|---|
| 001 | $a_i x^i + a_{i-1} x^{i-1} + \ldots + a_1 x + a_0$ |
| 002 | $b_i x^i + b_{i-1} x^{i-1} + \ldots + b_1 x + b_0$ |
| 003 | $c_i x^i + c_{i-1} x^{i-1} + \ldots + c_1 x + c_0$ |
| ... | ... |

302a

**Power Company (310)**

Connector (312)

- Business Intelligence (310a)
- Billing, Sales, Marketing (310b)
- Enterprise Asset Management (310c)
- ...

Fig. 3C

401

Computer System

SMART
METER

Processor

402

403

404 Interpolation
Component

Database

405

**Fig. 4A**

## Fig. 4B

**500**

Fig. 5

EP 2 456 076 A1

Europäisches
Patentamt

European
Patent Office

Office européen
des brevets

# EUROPEAN SEARCH REPORT

Application Number

EP 11 00 9243

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | anonymous: "Smart meter", wikipedia internet article, 27 October 2010 (2010-10-27), XP002671945, Retrieved from the Internet: URL:http://en.wikipedia.org/w/index.php?title=Smart_meter&oldid=393257694 [retrieved on 2012-03-21] * the whole document * | 1-15 | INV. H03M7/30 |
| X | Gordon K. Smyth: "Polynomial Approximation", internet article, 1998, XP002671944, Retrieved from the Internet: URL:http://www.statsci.org/smyth/pubs/EoB/bap064-.pdf [retrieved on 2012-03-21] * page 1 - page 3 * | 1-15 | |
| A | Wikipedia: "Polynominterpolation", internet article, 21 November 2010 (2010-11-21), XP002671946, Retrieved from the Internet: URL:http://de.wikipedia.org/w/index.php?title=Polynominterpolation&oldid=81776456 [retrieved on 2012-03-21] * the whole document * | 1-15 | TECHNICAL FIELDS SEARCHED (IPC) H03M |

The present search report has been drawn up for all claims

| Place of search | Date of completion of the search | Examiner |
|---|---|---|
| The Hague | 21 March 2012 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 456 076 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JEFFREY DEAN ; SANJAY GHEMAWAT.** MapReduce: Simplified Data Processing on Large Clusters. *OSDI'04: Sixth Symposium on Operating System Design and Implementation,* 2004